# EUROPEAN PATENT APPLICATION

(11) **EP 4 624 627 A1**
(43) Date of publication of application: **01.10.2025**
(21) Application number: 24167150.2
(22) Date of filing: 28.03.2024
(51) Int. Cl.: C23C 28/04, C23C 16/02, C23C 16/36, C23C 16/40, C23C 16/56, C23C 30/00

(54) **A COATED CUTTING TOOL**

(71) Applicant: AB Sandvik Coromant, 811 81 Sandviken (SE)
(72) Inventor: von Fieandt, Linus, 811 81 SANDVIKEN (SE); Morjan Brenning, Raluca, 811 81 SANDVIKEN (SE); Shoja, Siamak, 811 81 SANDVIKEN (SE); Engqvist, Jan, 811 81 SANDVIKEN (SE)
(74) Representative: Sandvik

(57) **Abstract**

The present invention relates to a cutting tool comprising a substrate at least partially coated with a coating, said coating comprises an α-Al₂O₃ layer and at least one inner Ti(C,N) layer, said inner Ti(C,N) layer is located between a surface of the substrate and the α-Al₂O₃ layer. The coating further comprises at least one outer Ti(C,N) layer located between the α-Al₂O₃ layer and an outermost surface of the coating. There is an intermediate layer between the α-Al₂O₃ layer and the outer Ti(C,N) layer, and said intermediate layer is a (Al,Ti)(C,O) layer with an average thickness of 100-600 nm.

## Description

### TECHNICAL FIELD

The present invention relates to a coated cutting tool. The cutting tool is coated with a CVD coating comprising an inner Ti(C,N) layer, an α-Al₂O₃-layer and an outer Ti(C,N) layer.

### BACKGROUND

Coated cutting tools are well known in the metal cutting industry. CVD coated cutting tools and PVD coated cutting tools are the two dominating types of coated cutting tools. Advantages with these coatings are high resistance to chemical and abrasive wear which are important to achieve long tool life of the cutting tool. CVD coatings comprising a layer of Ti(C,N) together with a layer of alumina are known to perform well in for example turning or milling of steel.

It is an object of the present invention to provide a cutting tool with an increased lifetime in metal cutting. It is also an object of the present invention to provide a cutting tool with high resistance to flaking of the coating during metal cutting in steel.

### DESCRIPTION OF THE INVENTION

At least one of the above-mentioned objects is achieved by a cutting tool according to claim 1. Preferred embodiments are disclosed in the dependent claims.

The present invention relates to a cutting tool comprising a substrate at least partially coated, said coating comprises an α-Al₂O₃ layer and at least one inner Ti(C,N) layer, said inner Ti(C,N) layer is located between a surface of the substrate and the α-Al₂O₃ layer, the coating further comprises at least one outer Ti(C,N) layer located between the α-Al₂O₃ layer and an outermost surface of the coating, wherein there is an intermediate layer between the α-Al₂O₃ layer and the outer Ti(C,N) layer, said intermediate layer is an (AI,Ti)(C,O) layer with an average thickness of 100-600 nm
It has recently been found that a coating comprising an inner Ti(C,N) layer, an intermediate α-Al₂O₃ layer and an outer wear layer of Ti(C, N) as an outer or outermost layer on a coated cutting tool is advantageous in crater wear resistance when turning in steel, such as medium carbon steel. It was unexpectedly found that by introducing a layer of (AI,Ti)(C,O) with a thickness of 100-600 nm between the outer Ti(C, N) layer and the α-Al₂O₃ layer in the coating of the cutting tool, the wear resistance of the cutting tool was improved, especially the coating adhesion in turning in medium carbon steel was improved.

The term "cutting tool" is herein intended to denote cutting tools suitable for metal cutting applications such as inserts. The application areas can for example be turning, milling or drilling in metals such as steel.

The coated cutting tool disclosed herein can be an insert comprising a rake face, a flank face and a cutting edge therebetween. The substrate, the coating and the layers thereof each have an outer surface. With surface normal or normal to the outer surface is intended a direction perpendicular to a surface plane of the outer surface, i.e in the preferential growth direction of the coating.

Cemented carbide materials are useful in high demanding applications due to their high hardness and high wear resistance in combination with high toughness. Cemented carbides are produced by powder metallurgical methods, wherein the starting powders are mixed, milled and formed into a green body, pre-sintered and sintered.

Cemented carbide materials generally consist of hard constituents of WC and optional carbides and/or nitrides such as TiC, NbC and TiN in a metallic binder of for example Co or Co in combination with Ni and Fe.

In one embodiment of the present invention the average thickness of said (AI,Ti)(C,O) layer is 100-400 nm, preferably 100-300 nm. In one embodiment the average thickness of said (AI,Ti)(C,O) layer is 150-300 nm.

In one embodiment of the present invention the average grain size of the Ti(C,N) grains in the outer Ti(C,N) layer, as measured with EBSD on a cross section of said outer Ti(C,N) layer, wherein a surface normal of the outer Ti(C,N) layer is parallel to the surface normal of the substrate surface, the average grain size is ≤ 350 nm, preferably 250-350 nm.

In one embodiment of the present invention the Al content in (AI,Ti)(C,O) layer is such that the atomic ration AI/(Ti+AI) is 3-5 %, preferably about 4 %.

In one embodiment of the present invention as measured with EBSD on an analysed area of a cross section of outer Ti(C, N) layer, wherein a surface normal of the outer Ti(C, N) layer is parallel to the surface normal of the substrate surface, said cross section is parallel to the surface normal of the outer Ti(C,N) layer, and said layer exhibits an orientation such that ≥ 15%, preferably ≥20%, more preferably ≥ 30% of the analysed area has a <111> direction within 15 degrees from the surface normal of the outer Ti(C,N) layer.

In one embodiment of the present invention as measured with EBSD on an analysed area of a cross section of said outer Ti(C,N) layer, wherein a surface normal of Ti(C,N) layer is parallel to the surface normal of the substrate surface, said cross section is parallel to the surface normal of the outer Ti(C,N) layer, and said layer exhibits an orientation wherein 15-25 %, of the analysed area has a <111 > direction within 15 degrees from the surface normal of the outer Ti(C,N) layer.

In one embodiment of the present invention the average thickness of the outer Ti(C,N) layer is ≥ 2.5 µm, preferably 3-10 µm, more preferably 4-7 µm.

In one embodiment of the present invention the average thickness of the α-Al₂O₃ layer is ≥ 3 µm, preferably 3-10 µm, more preferably 4-7 µm.

In one embodiment of the present invention the average thickness of the inner Ti(C,N) layer is ≥3 µm, preferably 4-10 µm, more preferably 4-6 µm.

In one embodiment of the present invention as measured with EBSD on an analysed area of a cross section of said α-Al₂O₃ layer, wherein a surface normal of the α-Al₂O₃ layer is parallel to the surface normal of the substrate surface, said cross section is parallel to the surface normal of the α-Al₂O₃ layer, said α-Al₂O₃ layer exhibits an orientation wherein ≥ 80%, of the analysed area has a <001> direction within 15 degrees from the surface normal of the α-Al₂O₃ layer.

In one embodiment of the present invention as measured with EBSD on an analysed area of a cross section of the inner Ti(C,N) layer, wherein a surface normal of the inner Ti(C,N) layer is parallel to the surface normal of the substrate surface, said cross section is parallel to the surface normal of the inner Ti(C,N) layer, said layer exhibits an orientation wherein ≥ 70 % of the analysed area has a <211> direction within 15 degrees from the surface normal of the inner Ti(C,N) layer.

In one embodiment of the present invention the substrate is of cemented carbide.

In one embodiment of the present invention the average total thickness of the coating is 9-30 µm, preferably 10-20 µm.

In one embodiment of the present invention the coating comprises a bonding layer between the inner Ti(C,N) layer and α-Al₂O₃ layer, said bonding layer comprises at least one compound selected from the group of titanium carboxide, titanium oxynitride and titanium carboxynitride, preferably the thickness of the bonding layer is 0.5-2 µm.

In one embodiment of the present invention the coating comprises an innermost layer of TiN, preferably with a thickness of 0.1-0.5 µm.

In one embodiment of the present invention the coating comprises an inner Ti(C,N) layer with an average thickness of 4-6 µm, an α-Al₂O₃ layer with a thickness of 4-7 µm and an outer Ti(C, N) layer with a thickness of 3-7 µm.

In one embodiment of the present invention the coating comprises an inner Ti(C,N) layer with an average thickness of 3-10 µm, an α-Al₂O₃ layer with a thickness of 3-10 µm and an outer Ti(C,N) layer with a thickness of 2.5-10 µm.

Still other objects and features of the present invention will become apparent from the following definitions and examples considered in conjunction with the accompanying drawings.

### METHODS

### Coating deposition

The coatings in the examples below were deposited partly in a radial lonbond Bernex TM type CVD equipment 530L size capable of housing 10000 half-inch size cutting inserts and partly in a radial lonbond Bernex TM type CVD equipment 530S size capable of housing 7000 half-inch size cutting inserts.

### Laver thickness

The SEM investigations of the polished cross sections were carried out in a Carl Zeiss AG-Supra 40 type operated at 3kV acceleration voltage using a 30 µm aperture size. The images were acquired using a secondary electron detector. The layer thicknesses were measured in the SEM images of the cross sections.

### Composition of layers

The Al content in the (AI,Ti)(C,O) was measured with energy dispersive X-ray spectroscopy using a transmission electron microscope (TEM), wherein the measured area(s) were chosen so that the entire part of that area was within the (AI,Ti)(C,O) layer and the area(s) were chosen so that at least 200,000 nm² was measured.

More specifically, the samples for characterization of the intermediate layer by TEM was produced by manufacturing a thin foil specimen of the sample by the well known FIB in-situ lift out technique. A Helios Nanolab 650 using a Ga+ ion source was used for the sample preparation. The specimens were mounted on Omniprobe^{™} 5-post Cu grids. The target thickness for the thin-foils was approximately 100 nm. In order to minimize the ion beam-induced damage, low accelerating voltages of 5 kV and 2 kV, with respective ion currents of 49 pA and 24 pA, were used in the final thinning process. The Al content in the intermediate layer, for example in the (AI,Ti)(C,O), was measured by energy dispersive X-ray spectroscopy (EDS) in a CS- and Probe- corrected FEI Titan transmission electron microscope equipped with a Schottky FEG operated in scanning mode (STEM) at an accelerating voltage of 300 kV. A Bruker Super X EDS detector was used for the EDS measurements. The measured area(s) were chosen so that the entire part of that area was within the intermediate layer. And the area(s) were chosen so that at least 200,000 nm² was measured.

### Orientation of layers and grain size

The orientation of the layers and the grain size of the Ti(C,N) grains were measured using electron backscatter diffraction (EBSD), wherein the width of the analysed area was at least 80 µm in parallel with the substrate surface, the height of the analysed area was selected to include the whole layer thickness of the layer that was studied, and a step size of 50 nm was used.

More specifically, the analysis was performed on the coatings cross-section using a Zeiss Supra 55 equipped with Oxford Instruments Symmetry EBSD detector. The coating cross-sections were prepared for CNMG120408-PM inserts which were baked in a black conductive phenolic resin from AKASEL, ground down about 1 mm and polished in two steps: rough polishing (9 µm) and fine polishing (1 µm) using a diamond slurry solution followed by a final polishing using colloidal silica solution. After the final polishing step, the as-baked inserts were cleaned in ethanol, nitrogen blow dried and mounted on a 70° pre-tilted holder for EBSD analysis. The microscope was operated at an acceleration voltage of 20 kV, and 13 nA beam current (120 µm aperture) and a working distance of 9-15 mm.

Regions which included all the sub layers (inner Ti(C,N), Al₂O₃ and outer Ti(C,N)) of at least 80 µm width was analyzed with a step size of 50nm, Speed 1 binning mode was used (622x512 pix). One auto-clean up step was applied to the data. The Aztec Crystal software (v 3.1, build 3.1.390) was used for the determination of the grain size and orientation.

The Alumina (Alpha), Acta Crystallogr, Sec B [ACBCAR], (1993) vol 49B pp 973-980, reference pattern was used for the Al₂O₃ measurements, 89 reflectors were used for the measurements.

The Ti(C,N), J.Electrochem. Soc. [JESOAN], (1950), vol 97, pp 299-304, reference pattern was used for the Ti(C,N) measurements, 89 reflectors were used for the measurements.

The orientation of the layers was determined as the amount in (%) of an analyzed area that is within a certain angular deviation from a set fiber axis. The samples were analyzed so that the surface of the specimen was parallel to the substrate surface, thus ensuring that the coating out of plane orientation was parallel to the sample normal.

For the Al₂O₃ the <001> direction was chosen as the direction parallel to the surface normal. The texture component was calculated as the amount of analyzed area that was ≤15° deviation from the <001> Al₂O₃ direction.

For the outer Ti(C,N) the <111> direction was chosen as the direction parallel to the surface normal. The texture component was calculated as the amount of analyzed area that was ≤ 15° deviation from the <111> Ti(C,N) direction.

For the inner Ti(C, N) the <211> direction was chosen as the direction parallel to the surface normal. The texture component was calculated as the amount of analyzed area that was ≤ 15° deviation from the <211> Ti(C,N) direction.

The grain size of the layers was analyzed using the same EBSD data as the orientation analysis. The "fitted ellipse minor diameter" parameter was used for grain size determination, where grain size was determined by the arithmetic mean value of the analyzed layer. The measurement was done on grains whose entire area fell within the boundaries of the measured area.

### BRIEF DESCRIPTION OF DRAWINGS

Embodiments of the invention will be described with reference to the accompanying drawings.

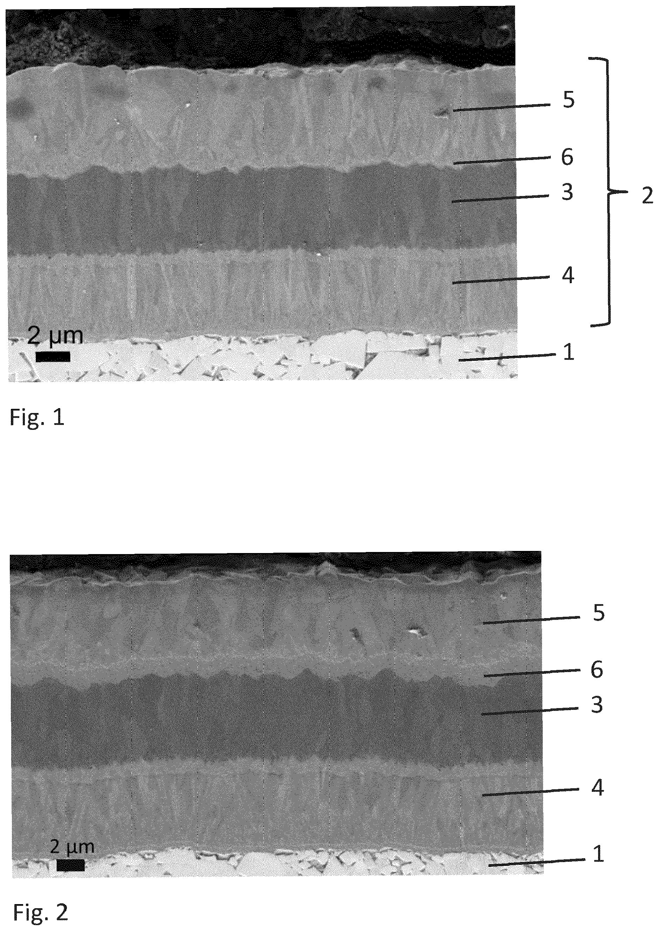

Figure 1 shows a Scanning Electron Microscope (SEM) image of a cross section of the CVD coating (2) of sample 2.2, with substrate (1), inner Ti(C,N) (4), Al₂O₃ layer (3), (AI,Ti)(C,O) layer (6) and the outer Ti(C,N) layer (5) indicated.
Figure 2 shows a Scanning Electron Microscope (SEM) cross section of the CVD layers in the sample Ref 6 with substrate (1), inner Ti(C,N) (4), Al₂O₃ layer (3), (AI,Ti)(C,O) layer (6) and the outer Ti(C,N) layer (5) indicated.

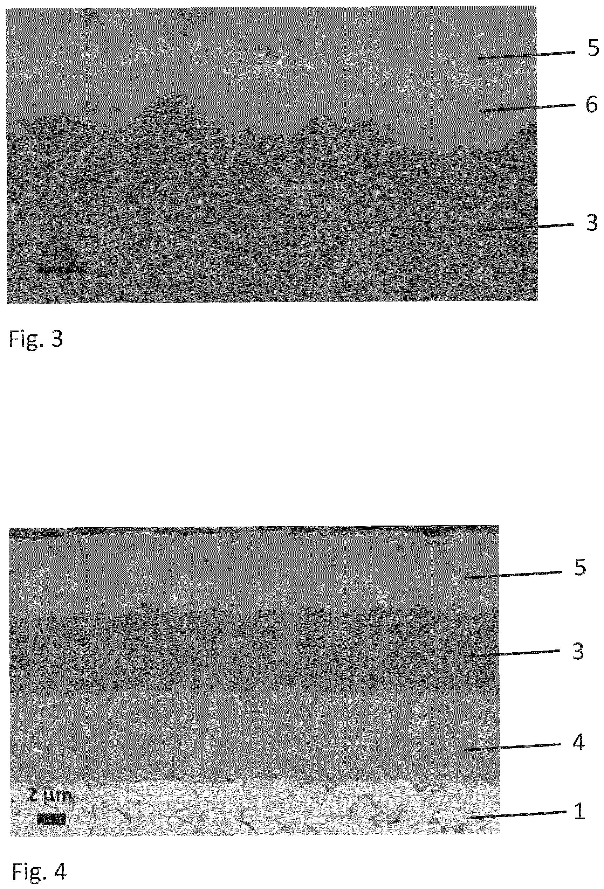

Figure 3 show a Scanning Electron Microscope (SEM) cross section of a close up of the sample Ref 6 with Al₂O₃ layer (3), (AI,Ti)(C,O) layer (6) and the outer Ti(C,N) layer (5) indicated.
Figure 4 show a Scanning Electron Microscope (SEM) cross section of the CVD layers of the sample Ref 3 without any (AI,Ti)(C,O) layer, with substrate (1), inner Ti(C,N) (4), Al₂O₃ layer (3) and the outer Ti(C,N) layer (5) indicated.

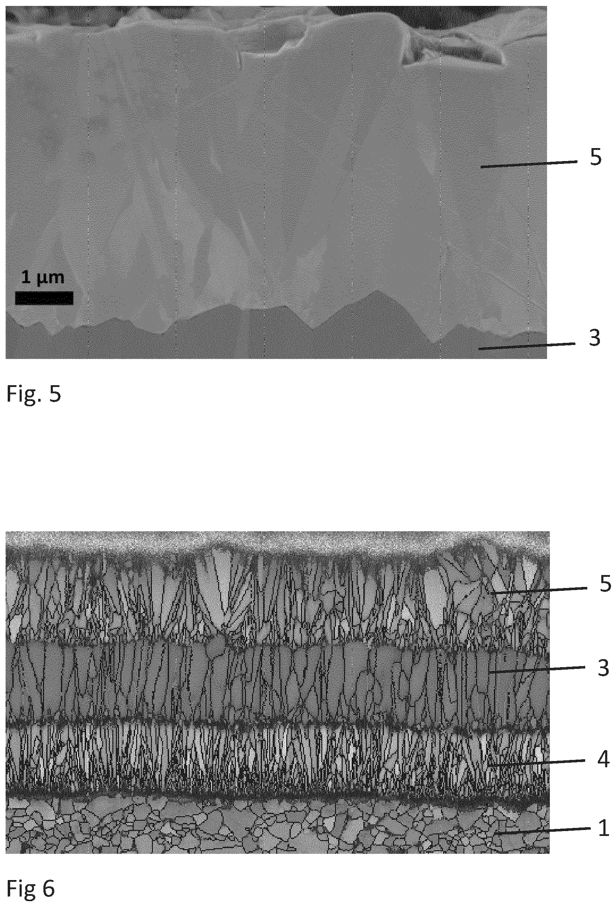

Figure 5 show a Scanning Electron Microscope (SEM) cross section of the sample Ref 3 with the Al₂O₃ layer (3) and the outer Ti(C,N) layer (5) indicated.
Figure 6 shows Electron Backscattered Diffraction (EBSD) map of the CVD layers of the sample 2.2, indicating the substrate (1), the inner Ti(C,N) layer (4), the Al₂O₃ layer (3) and the outer Ti(C,N) layer (5).

### EXAMPLES

Exemplifying embodiments of the present invention will be disclosed in more detail and compared to reference embodiments. The examples are to be considered as illustrative and not limiting embodiments. In the following examples coated cutting tools (inserts) were manufactured, analyzed and evaluated in cutting tests.

### Substrates

Cemented carbide substrates were manufactured utilizing conventional processes including milling, mixing, spray drying, pressing and sintering. The ISO-type geometry of the cemented carbide substrates (inserts) was CNMG-120408-PM. The composition of the cemented carbide was 7.2 wt% Co, 2.9 wt% TaC, 0.5 wt% NbC, 1.9 wt% TiC, 0.4 wt% TiN and the rest WC.

Before the coating depositions the substrates were exposed to a mild blasting treatment to remove any residuals on the substrate surfaces from the sintering process.

### Coating deposition processes

The sintered substrates were CVD coated in a radial CVD reactor of Bernex Type size 530L capable of housing 10.000 half inch size cutting inserts. The samples to be tested and analysed further were selected from the middle of the chamber and at a position along half the radius of the plate between the center and the periphery of the plate. Mass flow controllers are to be chosen so that the flow rate of for example CH₃CN is selected to allow the flow rates in the CVD recipe.

A first innermost layer of about 0.3 µm TiN was deposited on all substrates using a deposition temperature of 885 °C and a pressure of 400 mbar and a deposition time of 40 minutes. Thereafter a Ti(C,N) layer was deposited by employing the well-known MTCVD technique using TiCl₄, CH₃CN, N₂, HCl and H₂ at 885 °C and 55 mbar. Two steps were used, the first one for 10 minutes and the second step was adjusted to give a coating thickness of about 5 µm. The details of the TiN and the Ti(C,N) deposition are shown in Table 1.

**Table 1**

| MT CVD of TiN and Ti(C,N) (885°C): | Pressure [mbar] | H₂ [vol%] | N₂ [vol%] | HCl [vol%] | TiCl₄ [vol%] | CH₃CN [vol%] |
|---|---|---|---|---|---|---|
| Inner TiN | 400 | 48.8 | 48.8 | - | 2.44 | - |
| Inner Ti(C,N) step 1 | 55 | 59.0 | 37.6 | - | 2.95 | 0.45 |
| Inner Ti(C,N) step 2 | 55 | 81.5 | 7.8 | 7.8 | 2.38 | 0.65 |

After the deposition of the inner Ti(C,N) layer the temperature was increased from 885°C to 1000°C in an N₂ atmosphere.

A 0.7-1.1 µm thick bonding layer was deposited at 1000°C on top of the Ti(C,N) layer by a process consisting of four separate reaction steps. First a 8 minutes HTCVD Ti(C,N) step using TiCl₄, CH₄, N₂, HCl and H₂ at 400 mbar, then a second step (Ti(C,N,O)-1) using TiCl₄, CH₃CN, CO, N₂ and H₂ at 70 mbar for 7 minutes, then a third step (Ti(C,N,O)-2) using TiCl₄, CH₃CN, CO, N₂ and H₂ at 70 mbar for 5 minutes and finally a fourth step (TiN) using TiCl₄, N₂ and H₂ at 70 mbar for 6 minutes. During the third deposition step the CO gas flow was continuously linearly increased from a start value at the beginning of the process step to a stop value at the end of the process step as shown in Table 2. All other gas flows were kept constant, but since the overall gas flow is increased, the concentration of all gases was somewhat influenced due to this. Prior to the start of the subsequent Al₂O₃ nucleation, the bonding layer was oxidized for 4 minutes in a mixture of CO₂, CO, N₂ and H₂.

The details of the bonding layer deposition are shown in Table 2.

**Table 2. Bonding layer deposition**

| Bonding layer | Pressure [mbar] | H₂ [vol%] | N₂ [vol%] | CH₄ [vol%] | HCl [vol%] | CO [vol%] | TiCl₄ [vol%] | CH₃CN [vol%] | CO₂ [vol%] |
|---|---|---|---|---|---|---|---|---|---|
| Temp. increase | 55 | Balance | 25 | | | | | | |
| HTCVD Ti(C,N) | 400 | Balance | 25.5 | 3.4 | 1.7 | - | 1.55 | - | - |
| Ti(C,N,O)-1 | 70 | Balance | 120 | - | 1.2 | 1.2 | 1.5 | 0.40 | - |
| Ti(C,N,O)-2 | 70 | Balance | 31.5 - 30.6 | - | - | 1.6-4.6 | 3.15 - 306 | 0.65-0.63 | - |
| TiN | 70 | Balance | 32.3 | - | - | - | 323 | - | - |
| Oxidation | 55 | Balance | 30 | - | - | 12.5 | - | - | 37 |

On top of the bonding layer α-Al₂O₃ was deposited. All the α-Al₂O₃ layers were deposited at 1000°C and 55 mbar in two steps. The first step using 1.2 vol-% AlCl₃, 4.7 vol-% CO₂, 1.8 vol-% HCl and balance H₂ was run for 30 minutes giving about 0.1 µm α-Al₂O₃. The process time of the second step was adjusted to give a total α-Al₂O₃ layer thickness of about 5 µm. The second step of the α-Al₂O₃ layer was deposited using 1.2 % AlCl₃, 4.7 % CO₂, 2.9- % HCl, 0.58 % H₂S and balance H₂.

(AI,Ti)(C,O) or Ti(C,O) or (AI,Ti)N was deposited on top of the α-Al₂O₃ layers using a Bernex 530S CVD reactor in a reactor temperature of 1000°C and a pressure of 55 mBar. The samples to be tested and analysed further were selected from the middle of the chamber and at a position along half the radius of the plate between the center and the periphery of the plate. Deposition time was about 15 minutes for Ti(C,O) and (AI,Ti)(C,O) and about 30 minutes for (AI,Ti)N. The gas compositions are presented in Table 3.

**Table 3**

| Step | H2 (vol%) | N2 (vol%) | CO (vol%) | TiCl4 (vol%) | AlCl3 (vol%) |
|---|---|---|---|---|---|
| (AI,Ti)(C,O) | 90.5 | - | 3.5 | 1,7 | 4.3 |
| Ti(C,O) | 90.9 | - | 6.1 | 3.0 | - |
| (AI,Ti)N | 53.0 | 41.0 | - | 1.7 | 4.3 |

The outermost Ti(C,N) coating was deposited using either process type 1 or process type 2 as presented in Table 4.

**Table 4**

| Outer Ti(C, N) process | Temp [°C] | Pressure [mbar] | H₂ [vol%] | N₂ [vol%] | TiCl₄ [vol%] | CH₃CN [vol%] |
|---|---|---|---|---|---|---|
| Type 1 | 860 | 80 | Balance | 12.2 | 1.00 | 1.00 |
| Type 2 | 885 | 55 | Balance | 37.6 | 2.95 | 0.45 |

### Coating analyses

The layer thicknesses were measured on the rake face of the cutting tool samples using a Scanning Electron Microscope. The layer thicknesses of the samples are shown in Table 5.

**Table 5**

| Sample | TiN layer thickness [µm] | Inner Ti(C,N) layer thickness [µm] | Bonding layer thickness [µm] | α-Al₂O₃ layer thickness [µm] | Intermediate layer thickness [nm] | Outer Ti(C,N) layer thickness [µm] |
|---|---|---|---|---|---|---|
| Ref 0 | 0.25 | 4.3 | 0.75 | 4.9 | - | 3.99 |
| Ref 1 | 0.24 | 4.4 | 0.82 | 5.2 | 246 | 2.84 |
| Ref 2 | 0.25 | 4.3 | 0.78 | 5.0 | 202 | 3.22 |
| 1.1 | 0.24 | 4.3 | 0.84 | 5.1 | 235 | 2.69 |
| 1.2 | 0.24 | 4.3 | 0.8 | 5.1 | 222 | 2.88 |
| Ref 3 | 0.3 | 5.0 | 0.9 | 6.2 | - | 5.28 |
| Ref 4 | 0.3 | 4.7 | 0.8 | 6.2 | <50 | 4.40 |
| Ref 5 | 0.24 | 4.3 | 0.8 | 5.1 | 68 | 5.20 |
| 2.1 | 0.5 | 5.0 | 1.0 | 6.5 | 120 | 5.22 |
| 2.2 | 0.24 | 4.3 | 0.8 | 5.1 | 221 | 4.60 |
| 2.3 | 0.4 | 5.2 | 0.9 | 6.2 | 498 | 5.36 |
| Ref 6 | 0.5 | 5.4 | 1.0 | 6.2 | 1031 | 4.88 |

The composition of the (AI,Ti)(C,O) layer was analysed with energy dispersive X-ray spectroscopy and it was concluded that the AI/(AI+Ti) atomic ratio was 4.2%.

The orientation and the grain size in the inner Ti(C,N) layers and the α-Al₂O₃ layers were analysed with EBSD in accordance with the method described above. The inner Ti(C,N) layers showed an average grain size of 0.21 µm and 73.9% within 15° from (2 1 1).The α-Al₂O₃ layers showed an average grain size of 0.43 µm and 82.7% within 15° from (0 0 1).

A summary of the samples is shown in Table 6.

**Table 6**

| Sample | Intermediate layer | Intermedi ate layer thickness [nm] | Outer Ti(C,N) type | Outer Ti(C,N) thickness [µm] | % within 15° from 111 [%] | Grain size (fe minor [µm] |
|---|---|---|---|---|---|---|
| Ref 0 | - | - | 1 | 3.99 | 64.5 | 0.55 |
| Ref 1 | (Al,Ti)N | 246 | 1 | 2.84 | 83.3 | 0.64 |
| Ref 2 | Ti(C,O) | 202 | 1 | 3.22 | 44 | 0.39 |
| 1.1 | (Al,Ti)(C,O) | 235 | 1 | 2.69 | 32.9 | 0.32 |
| 1.2 | (Al,Ti)(C,O) | 222 | 1 | 2.88 | 37.7 | 0.32 |
| Ref 3 | - | - | 2 | 5.28 | 40.1 | 0.47 |
| Ref 4 | (Al,Ti)(C,O) | <50 | 2 | 4.40 | n.a.* | n.a.* |
| Ref 5 | (Al,Ti)(C,O) | 68 | 2 | 5.20 | 26.4 | 0.23 |
| 2.1 | (Al,Ti)(C,O) | 120 | 2 | 5.22 | 24 | 0.25 |
| 2.2 | (Al,Ti)(C,O) | 221 | 2 | 4.60 | 20.3 | 0.27 |
| 2.3 | (Al,Ti)(C,O) | 498 | 2 | 5.36 | 17.5 | 0.30 |
| Ref 6 | (Al,Ti)(C,O) | 1031 | 2 | 4.88 | 10.8 | 0.37 |

| | | | | | | |
|---|---|---|---|---|---|---|
| *n.a.=not analysed | | | | | | |

### Blasting test

The cutting tools were first evaluated by being exposed to an abrasive wet blasting. The blasting was performed on the rake faces of the cutting tools. The blaster slurry consisted of 20 vol-% alumina in water and an angle of 90° between the rake face of the cutting insert and the direction of the blaster slurry. The distance between the gun nozzle and the surface of the insert was about 145 mm. The pressure of the slurry to the gun was 1.8 bar for all samples, while the pressure of air to the gun was 2.2 bar. The alumina grits were F230 mesh (FEPA 42-2:2006). The average time for blasting per area unit was 4.4 seconds. The samples Ref 0, Ref 3, Ref 4 and Ref 5 showed flaking. All the other samples tested did withstand the wet blasting with no flaking of the coatings, see table 7.

**Table 7**

| Sample | Intermediate layer | Intermediate layer thickness [nm] | Outer Ti(C,N) type | Result |
|---|---|---|---|---|
| Ref 0 | - | - | 1 | some flaking |
| 1.1 | (Al,Ti)(C,O) | 235 | 1 | good |
| Ref 4 | (Al,Ti)(C,O) | <50 | 2 | total flaking |
| Ref 5 | (Al,Ti)(C,O) | 68 | 2 | total flaking |
| 2.1 | (Al,Ti)(C,O) | 120 | 2 | good |
| 2.3 | (Al,Ti)(C,O) | 221 | 2 | good |
| Ref 6 | (Al,Ti)(C,O) | 498 | 2 | good |
| Ref 3 | (Al,Ti)(C,O) | - | 2 | some flaking |

### Cutting test

The as coated cutting tools were also tested in a face turning operation (from dia. 180 mm to dia. 60mm) in a work-piece material DIN C45E, a medium carbon steel. The spindle speed was fixed in n = 120 rpm; thus, the cutting speed constantly varied from, Vc, ~70 m/min (at dia. 180 mm) to Vc, ~20 m/min ( at dia. 60 mm) along the face turning operation; the feed, fn, was constantly increased from 0.1mm/revolution (at dia. 180 mm), to 0.5 mm/revolution (at dia. 60 mm) along the face turning operation; the depth of cut was 2 mm and no cutting fluid was used. The test was stopped when the cutting piece material reached the 60 mm in diameter. Four samples of each variant were used. Three parallel tests were made, here called Run 1, Run 2 and Run 3.

In order to measure the total area of the damaged coating on the rake face after the face turning operation, the inserts were etched for 15 min in an HCl (Hydrochloric acid) solution. In the sequence, SEM investigations of the top surface were carried out using a Zeiss AG-Supra 40 type operated at 10 kV acceleration voltage using a 30 µm aperture size. Images were acquired at 50X magnification using a backscatter electron detector. Images were used to measure the area of coating ripped out using an image analysis software, where a larger measured area from table 8 corresponds to more wear due to unsatisfying adhesion of the top Ti(C,N).

**Table 8**

| Sample | Intermediate layer | Intermedi ate layer thickness [nm] | Outer Ti(C,N) type | Run 1 Coating damage [mm²] | Run 2 Coating damage [mm²] | Run 3 Coating damage [mm²] |
|---|---|---|---|---|---|---|
| Ref 0 | - | - | 1 | 1.06 | 1.17 | |
| Ref 1 | (Al,Ti)N | | 1 | 1.25 | | |
| Ref 2 | Ti(C,O) | | 1 | 0.99 | | |
| 1.1 | (Al,Ti)(C,O) | 235 | 1 | 0.94 | | 0.93 |
| 1.2 | (Al,Ti)(C,O) | 222 | 1 | | 0.82 | 0.67 |
| Ref 4 | (Al,Ti)(C,O) | <50 | 2 | | | 2.92 |
| Ref 5 | (Al,Ti)(C,O) | 68 | 2 | | | 3.55 |
| 2.1 | (Al,Ti)(C,O) | 120 | 2 | | | 0.56 |
| 2.2 | (Al,Ti)(C,O) | 221 | 2 | | 0.79 | 0.82 |
| 2.3 | (Al,Ti)(C,O) | 498 | 2 | | | 0.92 |
| Ref 6 | (Al,Ti)(C,O) | 1031 | 2 | | | 1.45 |

From cutting test 1 it is concluded that the samples 1.1, 1.2, 2.1, 2.2 and 2.3 showed less coating damage as compared to the reference samples Ref 0, Ref 1, Ref, 2, Ref 4, Ref 5 and Ref 6.

While the invention has been described in connection with various exemplary embodiments, it is to be understood that the invention is not to be limited to the disclosed exemplary embodiments; on the contrary, it is intended to cover various modifications and equivalent arrangements within the appended claims.

## Claims

1. A cutting tool comprising a substrate (1) at least partially coated with a coating (2), said coating comprises an α-Al₂O₃ layer (3) and at least one inner Ti(C,N) layer (4), said inner Ti(C,N) layer (4) is located between a surface of the substrate and the α-Al₂O₃ layer (3), the coating further comprises at least one outer Ti(C,N) layer (5) located between the α-Al₂O₃ layer (3) and an outermost surface of the coating (2), wherein there is an intermediate layer (6) between the α-Al₂O₃ layer (3) and the outer Ti(C,N) layer (5), said intermediate layer (6) is a (AI,Ti)(C,O) layer with an average thickness of 100-600 nm.

2. The cutting tool in accordance with claim 1, wherein the average thickness of said (AI,Ti)(C,O) layer is 100-400 nm, preferably 100-300 nm.

3. The cutting tool in accordance with any of the preceding claims, wherein the average grain size of the Ti(C,N) grains in the outer Ti(C,N) layer (5), as measured with EBSD on a cross section of said outer Ti(C,N) layer, wherein a surface normal of the outer Ti(C,N) layer is parallel to the surface normal of the substrate surface, the average grain size is ≤ 350 nm, preferably 250-350 nm.

4. The cutting tool in accordance with any of the preceding claims, wherein the Al content in (AI,Ti)(C,O) layer is such that the atomic ration AI/(Ti+AI) is 3-5 %, preferably about 4 %.

5. The cutting tool in accordance with any of the preceding claims, wherein as measured with EBSD on an analysed area of a cross section of the outer Ti(C,N) layer, wherein a surface normal of outer Ti(C,N) layer is parallel to the surface normal of the substrate surface, said cross section is parallel to the surface normal of the outer Ti(C,N) layer, and said layer exhibits an orientation wherein ≥ 15%, preferably ≥ 20%, more preferably ≥ 30% of the analysed area has a <111> direction within 15 degrees from the surface normal of the outer Ti(C,N) layer.

6. The cutting tool in accordance with any of the preceding claims, wherein as measured with EBSD on an analysed area of a cross section of said outer Ti(C,N) layer, wherein a surface normal of outer Ti(C,N) layer is parallel to the surface normal of the substrate surface, said cross section is parallel to the surface normal of the outer Ti(C,N) layer, and said layer exhibits an orientation wherein 15-25 %, of the analysed area has a <111> direction within 15 degrees from the surface normal of the Ti(C,N) layer.

7. The cutting tool in accordance with any of the preceding claims, wherein the average thickness of the outer Ti(C,N) layer is ≥ 2.5 µm, preferably 3-10 µm, more preferably 4-7 µm.

8. The cutting tool in accordance with any of the preceding claims, wherein the average thickness of the α-Al₂O₃ layer is ≥ 3 µm, preferably 3-10 µm, more preferably 4-7 µm.

9. The cutting tool in accordance with any of the preceding claims, wherein the average thickness of the inner Ti(C,N) layer is ≥ 3 µm, preferably 4-10 µm, more preferably 4-6 µm.

10. The cutting tool in accordance with any of the preceding claims, wherein as measured with EBSD on an analysed area of a cross section of said α-Al₂O₃ layer, wherein a surface normal of the α-Al₂O₃ layer is parallel to the surface normal of the substrate surface, said cross section is parallel to the surface normal of the α-Al₂O₃ layer, and said layer exhibits an orientation wherein ≥ 80 %, of the analysed area has a <001> direction within 15 degrees from the surface normal of the α-Al₂O₃ layer.

11. The cutting tool in accordance with any of the preceding claims, wherein as measured with EBSD on an analysed area of a cross section of the inner Ti(C,N) layer, wherein a surface normal of inner Ti(C,N) layer is parallel to the surface normal of the substrate surface, said cross section is parallel to the surface normal of the inner Ti(C,N) layer, and said layer exhibits an orientation wherein ≥ 70 % of the analysed area has a <211> direction within 15 degrees from the surface normal of the inner Ti(C,N) layer.

12. The cutting tool in accordance with any of the preceding claims, wherein the substrate is of cemented carbide.

13. The cutting tool in accordance with any of the preceding claims, wherein an average thickness of the coating is 9-30 µm, preferably 10-20 µm.

14. The cutting tool in accordance with any of the preceding claims, wherein the coating comprises an inner Ti(C,N) layer with an average thickness of 3-10 µm, an α-Al₂O₃ layer with a thickness of 3-10 µm and an outer Ti(C, N) layer with an average thickness of 2.5-10 µm.
